# EUROPEAN PATENT SPECIFICATION

(11) **EP 1 661 867 B1**
(45) Date of publication and mention of the grant of the patent: **13.05.2009**
(21) Application number: 05019047.9
(22) Date of filing: 01.09.2005
(51) Int. Cl.: C03C 17/34, C23C 16/02, C23C 16/40

(54) **Article with photocatalytic film**
Artikel mit photokatalytische Beschichtung
Article avec revêtement photocatalytique

(30) Priority: 19.11.2004 JP 2004335697
(43) Date of publication of application: 31.05.2006
(73) Proprietor: Murakami Corporation, Shizuoka-shi Shizuoka 422-8569 (JP)
(72) Inventor: Kikuchi, Hideyuki, Fujieda-shi Shizuoka 426-0053 (JP); Kobayashi, Masaki, Fujieda-shi Shizuoka 426-0053 (JP)
(74) Representative: Krauss, Jan

(56) References cited:
- EP-A- 0 820 967
- EP-A- 0 978 494
- US-B1- 6 379 776
- PATENT ABSTRACTS OF JAPAN vol. 1999, no. 08, 30 June 1999 (1999-06-30) & JP 11 071686 A (NISSHIN STEEL CO LTD), 16 March 1999 (1999-03-16)

## Description

### Background of the Invention

### Field of the Invention

This invention generally relates to a method of adding sufficient photocatalytic property to a member, as well as provision of a member to which sufficient photocatalytic property has been added; wherein the member is any of various member products (metal member products or resin member products) on which addition of photocatalytic property, etc., has not been attempted before and wherein formation of photocatalytic film and hydrophilic film in layers in this order on such member using the deposition method, sputter method or CVD method does not guarantee manifestation of actual photocatalytic action and benefits therefrom.

### Description of the Related Art

Research of photocatalytic film has been conducted actively with extreme interest of late (refer to Japanese Patent Laid-open No. 2000-53449 and No. 2004-2104 by the applicant, for example). A number of patent applications have been filed, with each application presenting a different view. In a way, the technologies available today are a mixture of effective and non-effective methodologies. In addition, many of the patent applications relating to photocatalyst tend to cover a broad scope, and depending on the applicable condition, etc., some applications include in their scope of invention those areas not conceivable in the applicable industry based on commonsense (for example, the range of values obtained by the experiment varies significantly under particular conditions, etc., which makes it impossible to generalize the application to include different conditions, i.e., the intended effect cannot be obtained widely). Even when similar patent applications showing relative validity are compared against one another (by way of comparing the ranges of values, etc., for example), inconsistencies are often found.

In the case of camera lenses (or hood lenses) used outdoors or in similar conditions, the field of view will deteriorate if water droplets or soiling attaches to the lens or glass surface. Particularly among camera lenses installed in outdoor locations, those used in high places as surveillance cameras or in other locations where maintenance is difficult will suffer undesirable consequences if droplets or soiling attaches to the lens and the field of view deteriorates, because the lens cannot be cleaned easily.

To address this problem, attempts have been carried out in recent years to add a hydrophilic film, or a hydrophilic photocatalytic film providing both hydrophilicity and photocatalytic property, on the surfaces of camera lenses, etc.

However, water droplets are collected not only on the camera lens but also a retention member (a peripheral member called "retainer") installed on the outer periphery of the camera lens, etc. If water droplets are collected on the retainer, they tend to cause attachment of soiling developing toward the lens.

EP 0 978 484 A1 discloses an anti-fog mirror with a film structure comprising a surface of a mirror, a photocatalyzing TiO₂ film on the mirror surface and a porous SiO₂ film on the TiO₂ film, wherein the SiO₂ film has a surface roughness of 2 nm or more.

EP 0 820 967 A1 discloses an anti-fog element comprising a transparent substrate, a photocatalyzing TiO₂ film formed on the substrate and a transparent porous SiO₂ film formed on the TiO₂ film, wherein the SiO₂ film has a surface exhibiting a hydrophilic property.

### Summary of the Invention

In an embodiment, an object of the present invention is to provide an article that surely exhibits and maintains a desired level of photocatalytic performance to prevent attachment of water droplets and soiling. In another embodiment, an object of the present invention is to provide an article that exhibits and maintains a desired level of photocatalytic performance to prevent attachment of oil dirt or grease and promote removal of oil dirt or grease. In yet another embodiment, an object of the present invention is to provide a method of obtaining a surface surely exhibiting and maintaining a desired level of photocatalytic performance to prevent attachment of water droplets and soiling or prevent attachment of oil dirt or grease and promote removal of oil dirt or grease. In still another embodiment, an object of the present invention is to provide a method of manufacturing an article having the surface.

In an aspect which realizes one or more of the objects above, the prevent invention provides an article according to claim 1.

The hydrophilic film can render the surface more hydrophilic and reduce a water-droplet contact angle on the surface, thereby spreading water on the surface in a very thin layer which can protect the surface from soling substances attaching to the surface. Further, the photocatalytic film can cause photocatalytic action or oxidation against the soiling substances and decompose them.

The above aspect includes, but is not limited to, the following embodiments:

The photocatalytic film and the hydrophilic film may be films deposited by physical or chemical vapor deposition (PVD or CVD).

A surface of the hydrophilic film may have a water-droplet contact angle of about 20° or less as measured after being irradiated for 24 hours with a black light having an intensity of 1.0 mW/cm².

The article may be a camera comprising a camera lens or hood glass and a retainer retaining the camera lens or hood glass at its outer periphery, wherein the surface comprises a surface of the retainer. The surface of the retainer may have an Ra of 0.60-0.78 µm, and a surface of the hydrophilic film may have a water-droplet contact angle of about 15° to about 20° as measured after being irradiated for 24 hours with a black light having an intensity of 1.0 mW/cm².

The article may be a bicycle part, wherein the surface comprises a surface of the bicycle part. The article may be a laser radar device comprising a laser radar unit and a laser radar cover member, wherein the laser radar cover member is a polyimide resin molding, and the surface comprises a surface of the laser radar cover member. The surface of the laser radar cover member may have an Ra of 0.2 µm or less, and a surface of the hydrophilic film may have a water-droplet contact angle of about 4° or less as measured after being irradiated for 24 hours with a black light having an intensity of 1.0 mW/cm².

In another aspect, in an article having a surface which has an arithmetic-average surface roughness (Ra) of more than 0.78 µm as measured in an area of 100 µm x 100 µm by a laser microscope and is exposed to the external environment, the present invention provides the improvement comprises: (i) the surface being treated to have an arithmetic-average surface roughness (Ra) of 0.78 µm or less as measured in an area of 100 µm x 100 µm by a laser microscope; (ii) a photocatalytic film deposited on the surface; and (iii) a hydrophilic film deposited on the photocatalytic film.

All of the aforesaid embodiments can be applied to the above aspect singly or in any combination. Further, in all of the aforesaid embodiments, any element used in an embodiment can interchangeably be used in another embodiment unless such a replacement is not feasible or causes adverse effect. Further, the present invention can apply equally to a method described below.

In yet another aspect, the present invention provides a method of producing an article manifesting photocatalytic action, comprising: (i) determining an area of an article, which is to manifest photocatalytic action; (ii) determining whether the area has an arithmetic-average surface roughness (Ra) of 0.78 µm or less as measured in an area of 100 µm x 100 µm by a laser microscope; (iii) if Ra is more than 0.78 µm, adjusting the Ra to 0.78 µm or less; (iv) forming a photocatalytic film on the area by physical or chemical vapor deposition; and (v) forming a hydrophilic film on the photocatalytic film by physical or chemical vapor deposition.

The above aspect includes, but is not limited to, the following embodiments and any embodiments described above:

A surface of the hydrophilic film may be a water-droplet contact angle of about 20° or less as measured after being irradiated for 24 hours with a black light having an intensity of 1.0 mW/cm². The photocatalytic film may be constituted by TiO₃. The hydrophilic film may be constituted by SiO₂.

The article may be a camera comprising a camera lens or hood glass and a retainer retaining the camera lens or hood glass at its outer periphery, wherein the area comprises a surface of the retainer. The step of adjusting the Ra may comprise adjusting the Ra to 0.60-0.78 µm, wherein a surface of the hydrophilic film has a water-droplet contact angle of about 15° to about 20° as measured after being irradiated for 24 hours with a black light having an intensity of 1.0 mW/cm².

The article may be a bicycle part, wherein the area comprises a surface of the bicycle part. The article may be a laser radar device comprising a laser radar unit and a laser radar cover member, wherein the laser radar cover member is a polyimide resin molding, and the surface comprises a surface of the laser radar cover member. The step of adjusting the Ra may comprise adjusting the Ra to 0.2 µm or less, wherein a surface of the hydrophilic film has a water-droplet contact angle of about 4° or less as measured after being irradiated for 24 hours with a black light having an intensity of 1.0 mW/cm².

In still another aspect, the present invention provides a method of producing an article manifesting photocatalytic action, comprising: (i) obtaining a regression line or regression expression or both of a relationship between arithmetic-average surface roughness (Ra) of a base surface of an article as measured in an area of 100 µm x 100 µm by a laser microscope and a water-droplet contact angle (Ca) of a top surface of the article as measured after being irradiated for 24 hours with a black light having an intensity of 1.0 mW/cm², wherein a photocatalytic film and a hydrophilic film are formed in sequence on the base surface by physical or chemical vapor deposition under a given condition; (ii) selecting an article-to-be-treated; (iii) determining a target Ca of an area of the article; (iv) determining a target Ra of the area which is 0.78 µm or less for the target Ca based on the regression line or regression expression or both; (v) processing the area to adjusting its Ra to the target Ra; and (vi) forming a photocatalytic film and a hydrophilic film in sequence on the area by physical or chemical vapor deposition under the given condition.

The above aspect includes, but is not limited to, the following embodiment and any embodiments described above:

The step of obtaining the regression line or regression expression or both may use different articles made of different materials.

In all of the aforesaid embodiments, any element used in an embodiment can interchangeably be used in another embodiment unless such a replacement is not feasible or causes adverse effect. Further, the present invention can equally be applied to apparatuses and methods.

For purposes of summarizing the invention and the advantages achieved over the related art, certain objects and advantages of the invention have been described above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

Further aspects, features and advantages of this invention will become apparent from the detailed description of the preferred embodiments which follow.

### Brief Description of the Drawings

These and other features of this invention will now be described with reference to the drawings of preferred embodiments which are intended to illustrate and not to limit the invention.

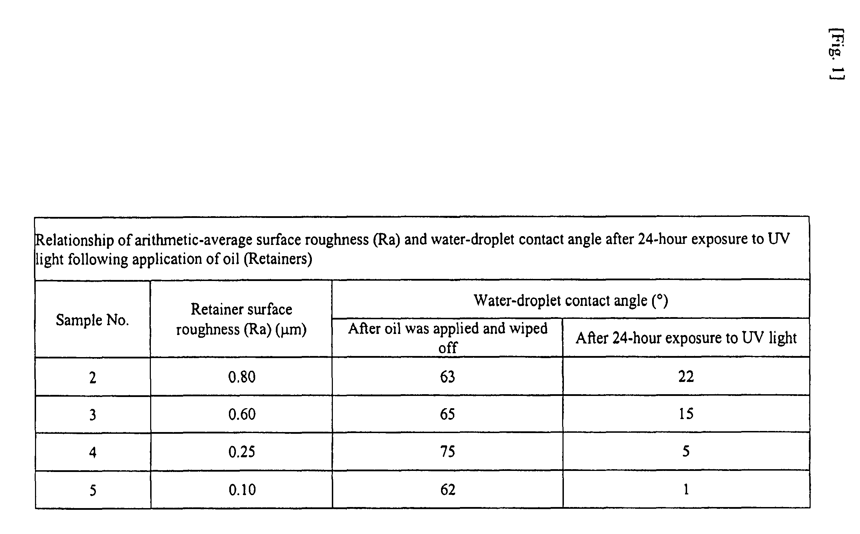

Fig. 1 is a table showing the relationship of the arithmetic-average surface roughness (Ra) before film formation and the water-droplet contact angle after exposure to 1.0 mW/cm² of UV light for 24 hours following film formation and application of engine oil, with respect to retainers.

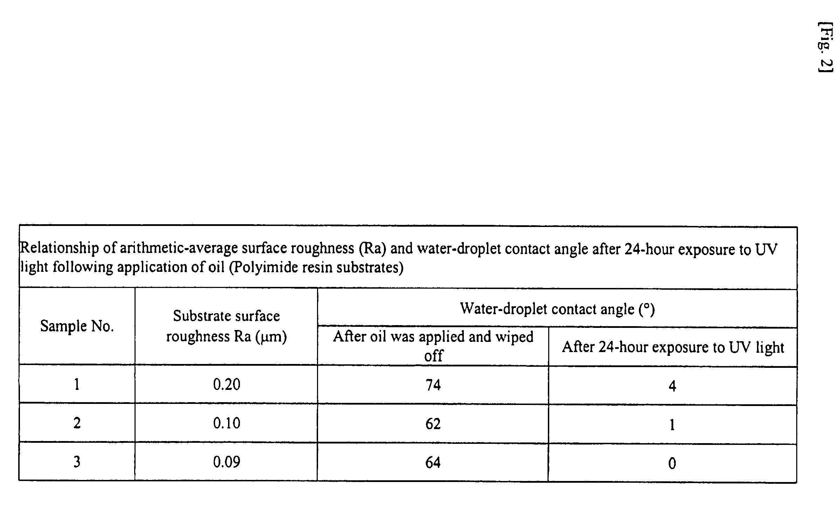

Fig. 2 is a table showing the relationship of the arithmetic-average surface roughness (Ra) before film formation and the water-droplet contact angle after exposure to 1.0 mW/cm² of UV light for 24 hours following film formation and application of engine oil, with respect to laser radar covers (substrate material: polyimide).

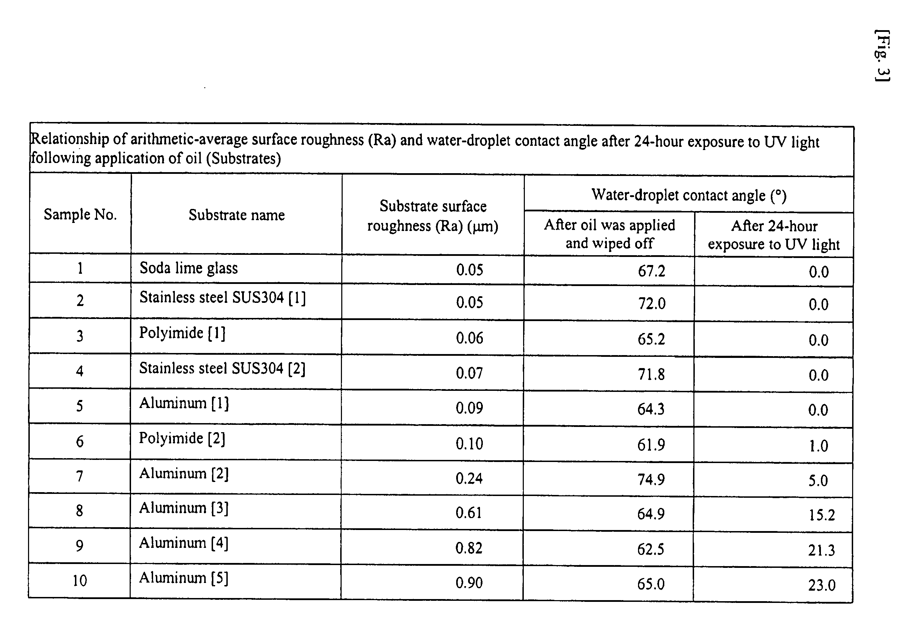

Fig. 3 is a table showing the relationship of the arithmetic-average surface roughness (Ra) before film formation and the water-droplet contact angle after exposure to 1.0 mW/cm² of UV light for 24 hours following film formation and application of engine oil, with respect to substrates of various types.

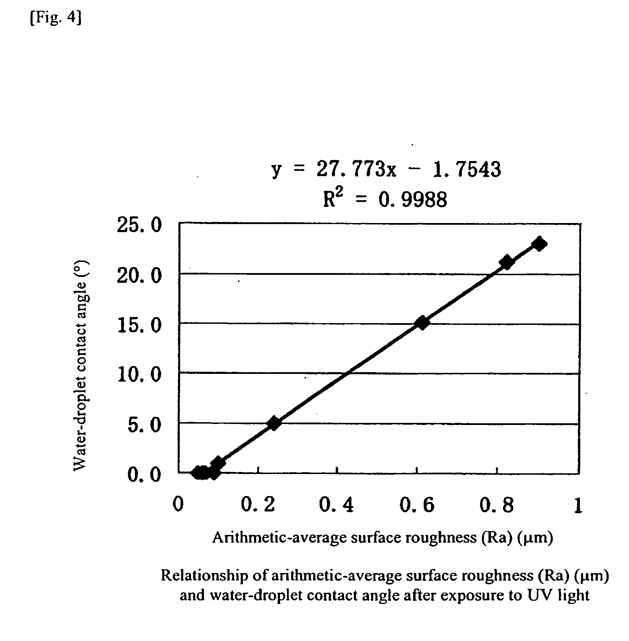

Fig. 4 is a plot showing the relationship of the arithmetic-average surface roughness (Ra) before film formation and the water-droplet contact angle after exposure to 1.0 mW/cm² of UV light for 24 hours following film formation and application of engine oil, with respect to substrates of various types.

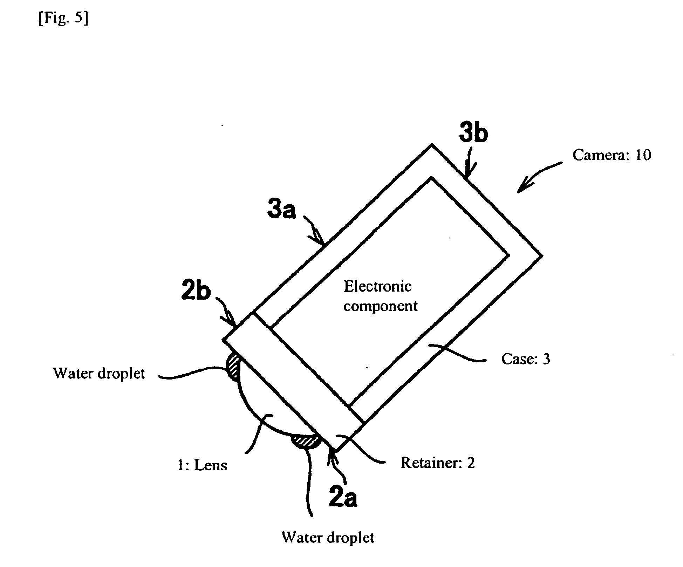

Fig. 5 is a schematic drawing showing a camera conforming to one embodiment of the present invention.

Explanation of the Symbols: 1: Lens; 2: Retainer; 3: Case; 10: Camera.

### Detailed Description of the Preferred Embodiment

The invention will be explained in detail with reference to experiments and preferred embodiments. However, the experiments and the preferred embodiments are not intended to limit the present invention.

As described in the background section, there was a problem of a deteriorating field of view resulting from water droplets collecting between the camera lens, etc., and the retention member (a peripheral member called "retainer") installed on the outer periphery of the camera lens, etc. (refer to Fig. 5 for the structure). In order to solve the problem, the applicant of the present invention had previously invented a technology to form a hydrophilic film on the surface of the aforementioned retention member and filed an application for patent covering this technology (Japanese Patent Application JP 2006091249). Here, forming a hydrophilic film on the surface of the aforementioned retention member will provide a significant effect. However, further improvements are possible from the viewpoint of maintaining long-term hydrophilicity to prevent attachment of soiling, etc. For this reason, the applicant developed a prototype comprising a structure of retention member/photocatalytic film/hydrophilic film, where a photocatalytic film and a hydrophilic film were formed in layers in this order on the surface of the aforementioned retention member using the deposition method, etc.

Contrary to the initial prediction, however, the prototype did not provide the expected effect. To be specific, the expected effect could not be achieved simply by forming photocatalytic film/hydrophilic film using the deposition method, sputter method or CVD method on the surface of a commercially available aluminum retainer with black alumite treatment.

At first, the reason for the failure was considered to be an inappropriate attachment of photocatalytic film/hydrophilic film on the retainer surface. However, a further investigation found no problem in the attachment condition of film. Next, black alumite treatment was suspected as a cause of the undesirable result. Accordingly, the condition for black alumite treatment was changed in various ways (specifically, by changing the conditions for abrasives such as alumina and ceric oxide or the conditions for buffing or electrolytic polishing, etc.) to produce retainers. When photocatalytic film/hydrophilic film were formed on the surfaces of the obtained retainers using the deposition method, sputter method or CVD method, some retainers exhibited the expected effect.

When the cause was further investigated, the inventors found, to their surprise, that slight differences in the roughness of retainer surface would determine whether sufficient photocatalytic property would or would not manifest. To be specific, simply forming photocatalytic film/hydrophilic film on the surface of a commercially available retainer with black alumite treatment (Ra = approx. 0.8 µm) did not cause the expected photocatalytic property to manifest (the result could not confirm manifestation of actual photocatalytic action), while forming photocatalytic film/hydrophilic film on the surface of a retainer treated with black alumite under a different condition (to adjust the Ra to 0.6 µm, for example) caused the expected photocatalytic property to manifest sufficiently.

When the black alumite treatment condition was further changed minutely (in various ways) to produce retainers having slightly varying surface roughness levels (in various ways), the relationship shown in Fig. 1 was revealed. In other words, the photocatalytic performance of each retainer varied significantly depending on the slight difference in its surface roughness, as shown in Fig. 1.

Based on the above tests, it was found that the expected photocatalytic property would sufficiently manifest and a level of hydrophilicity considered sufficient in practical applications (15° in the specified test as described in Example 1 later (hereinafter referred to as "the specified test" in this Specification)) would be maintained for a long period of time, by changing the surface roughness of a commercially available retainer with black alumite treatment (Ra = approx. 0.8 µm) to approx. 0.60 µm (0.60 µm ± 0.05 µm = 0.55 µm to 0.65 µm) by way of changing the black alumite treatment condition and then forming photocatalytic film/hydrophilic film on the surface of the retainer with an adjusted surface roughness using the deposition method, sputter method or CVD method.

Furthermore, it was also found that photocatalytic property would prominently manifest and a level of hydrophilicity considered prominent in practical applications (5° in the specified test) would be maintained for a long period of time, by producing a retainer with a surface roughness (Ra) of approx. 0.25 um (0.25 µm ± 0.05 µm = 0.20 µm to 0.30 µm) by way of changing the black alumite treatment condition and then forming photocatalytic film/hydrophilic film on the surface of the retainer with an adjusted surface roughness using the deposition method, sputter method or CVD method.

Yet further, it was also found that photocatalytic property would more prominently manifest and a level of hydrophilicity considered almost perfect in practical applications (1° in the specified test) would be maintained for a long period of time, by producing a retainer with a surface roughness (Ra) of approx. 0.10 µm (0.10 µm ± 0.05 µm = 0.095 µm to 0.15 µm) by way of changing the black alumite treatment condition and then forming photocatalytic film/hydrophilic film on the surface of the retainer with an adjusted surface roughness using the deposition method, sputter method or CVD method.

On the other hand, it was found that in producing a retainer having a surface roughness (Ra) of approx. 0.10 µm (0.10 µm ± 0.05 µm = 0.095 µm to 0.15 µm) by changing the black alumite treatment condition, some issues relating to labor, cost, mass production and quality control had to be solved.

To be specific, pursuit of better surface roughness requires too much labor and cost and is therefore not practical. In terms of mass production and quality control, such effort often results in poor yield and lower productivity. It also incurs a lot of labor and costs in controlling the quality beyond the practical levels. In addition, a retainer with black alumite treatment generates gloss if its arithmetic-average surface roughness (Ra) is 10 µm or less, in which case the light reflected on the retainer may enter the lens and cause an undesirable effect called halation.

On the other hand, a retainer with black alumite treatment having an arithmetic-average surface roughness (Ra) of over 10 µm can be used favorably, because it does not generate gloss and prevents occurrence of halation. In consideration of the above findings, it is desirable to keep the arithmetic-average surface roughness (Ra) of the retainer with black alumite treatment to over 0.10 µm. Ra should be 0.15 µm or more, or preferably 0.20 µm or more, in terms of achieving a better balance of desired photocatalytic performance on one hand and the requirements for labor, cost, mass production and quality control on the other. In order to cause photocatalytic property to manifest sufficiently and obtain the expected effect, the Ra should ideally be 0.65 µm or less. In order to cause photocatalytic property to manifest prominently, a Ra of 0.30 µm or less is more preferable.

Laser radars used for the purpose, among others, of measuring the distance between the subject vehicle and preceding vehicle to control the speed of the subject vehicle accordingly are equipped on certain luxury vehicles to ensure safer vehicle operation. If water droplets or soiling attaches to the cover of a laser radar installed on a vehicle, etc., the laser beam will be scattered and radar sensitivity will drop. In other words, these laser radar devices have a room for further improvement to address the problem of sensitivity drop due to attached water/soiling.

In view of this situation, concurrently with the aforementioned experiment the inventors of the present invention developed a prototype comprising a structure of cover member/photocatalytic film/hydrophilic film, where a photocatalytic film and a hydrophilic film were formed in layers in this order on the surface of the cover of a laser radar used for the purpose, among others, of measuring the distance between the subject vehicle and preceding vehicle to control the speed of the subject vehicle accordingly.

To be specific, first the aforementioned photocatalytic film/hydrophilic film was formed on the surface of a laser radar cover made of glass, using the wet method (coating, firing, etc.), deposition method, etc. However, although the expected effect was obtained in terms of sufficient manifestation of photocatalytic property, the glass surface was found highly vulnerable to cracking due to contact with small stones, etc., that were kicked into air by the wheels of the preceding vehicle.

Next, the aforementioned photocatalytic film/hydrophilic film was formed on the surface of a laser radar cover made of common acrylic resin (substrate) using the wet method (coating, firing, etc.). In this case, however, the film did not adhere securely on the acrylic resin surface.

Next, the aforementioned photocatalytic film/hydrophilic film was formed on the surface of a laser radar cover made of common acrylic resin (substrate) using the deposition method. This time, acrylic resin did not have sufficient heat resistance to withstand the film forming temperature required by the deposition method to produce sufficient photocatalytic property.

Therefore, the aforementioned photocatalytic film/hydrophilic film were then formed on a polyimide resin (substrate) surface using the deposition method. Here, the level of photocatalytic performance varied significantly depending on the slight difference in the surface roughness of the polyimide resin substrate, as mentioned earlier. The same results based on the deposition method were also obtained with the sputter method and CVD method.

In other words, as shown in Fig. 2, even when photocatalytic film/hydrophilic film was formed on a polyimide resin substrate surface (Ra = 0.20 µm) using the deposition method, sputter method or CVD method, the photocatalytic property required of a laser radar cover did not sufficiently manifest (water-droplet contact angle of 4° in the specified test), and therefore the method was found inappropriate from the viewpoint of ensuring more stable laser radar sensitivity. Next, a die whose surface roughness was finely adjusted was created and this die was used to form a polyimide resin substrate (Ra = 0.10 µm). When photocatalytic film/hydrophilic film was formed on the surface of this polyimide resin substrate using the deposition method, sputter method or CVD method, the photocatalytic property expected of a laser radar cover manifested prominently (water-droplet contact angle of 1° in the specified test). Accordingly, this method was considered sufficient from the viewpoint of ensuring more stable laser radar sensitivity. Similarly, a different die whose surface roughness was finely adjusted was created and this die was used to form a polyimide resin substrate (Ra = 0.09 µm). When photocatalytic film/hydrophilic film was formed on the surface of this polyimide resin substrate using the deposition method, sputter method or CVD method, the photocatalytic property required of a laser radar cover manifested more sufficiently (water-droplet contact angle of 0° in the specified test). Therefore, this method was considered more sufficient from the viewpoint of ensuring more stable laser radar sensitivity.

It was also found that a laser radar cover made of polyimide resin would provide a molded product having a surface roughness corresponding to the surface roughness of its die that has been produced with a finely adjusted surface roughness according to the know-how obtained above. Specifically, use of polyimide resin would allow for mass production at a high yield and in a stable manner of a molded laser radar cover having a Ra of 60 to 100 nm that prominently exhibits photocatalytic property, and polyimide resin material would also provide excellent film adhesion and also ensure enough heat resistance to achieve sufficient photocatalytic performance using the deposition method, sputter method or CVD method.

Incidentally, covers for laser radars used for the purpose, among others, of measuring the distance between the subject vehicle and preceding vehicle to control the speed of the subject vehicle accordingly should most ideally have prominent hydrophilicity (anti-fogging property) as well as prominent photocatalytic property (anti-soiling property) that ensures that hydrophilicity (anti-fogging property) will be maintained for a long period of time. In this sense, these laser radar covers should preferably have a surface roughness (Ra) of 60 to 100 nm, or more preferably a Ra of 60 to 90 nm.

Traditionally, cleaning of soiled gears, disk brake rotors, hubs, or spokes and other parts near hubs on bicycles was a burdensome task. Attachment of oil on the disk brake rotor (especially the rear part is subject to significant oil stains) can reduce the performance of the part. However, it is difficult to clean the hub or spokes and nipples near the hub (especially the rear of these parts).

In view of this situation, concurrently with the aforementioned experiment the inventors of the present invention also developed a prototype comprising a structure of gear member/photocatalytic film/hydrophilic film, where a photocatalytic film and a hydrophilic film were formed in layers in this order on the surface of a bicycle gear (a gear on which hydrophilic photocatalytic film was formed).

Specifically, first the aforementioned photocatalytic film/hydrophilic film was formed on the surface of a bicycle gear made of stainless steel (SUS304) using the wet method (coating, firing, etc.). However, the film did not adhere securely on the SUS304 surface. When the aforementioned photocatalytic film/hydrophilic was formed using the deposition method, sputter method or CVD method on the surface of a bicycle gear made of stainless steel (SUS304), the level of photocatalytic performance varied significantly depending on the slight difference in the surface roughness of the bicycle gear, as mentioned earlier.

To be specific, when the aforementioned photocatalytic film/hydrophilic film was simply formed on the surfaces of two types of commercially available bicycle gears (Ra = 1.0 µm) using the deposition method, sputter method or CVD method, little photocatalytic property manifested. However, forming photocatalytic film/hydrophilic film on the surface of a bicycle gear produced with buffing (to adjust the Ra to 0.60 µm, for example) caused sufficient photocatalytic property to manifest.

However, gears and other bicycle parts have complex surface shapes (gear curves, curved surfaces, etc.), and therefore pursuit of uniform surface roughness over the entire surface of a member costs too much and is not practical at the present time. For example, producing a gear member whose entire surface is treated to a surface roughness (Ra) of 0.1 µm or less would require levels of labor, cost, mass production and quality control that are not practical and consequently present significant problems. In consideration of the above, it is preferable to give a single, uniform treatment on the entire surface of the gear member by means of alumite treatment, etc., to produce a gear member having a surface roughness (Ra) in a range of 0.65 µm or less but not below 0.30 µm over its entire surface-from the viewpoint of labor, cost, mass production and quality control (this way, a gear member having a surface roughness (Ra) in a range of 0.65 µm or less but not below 0.30 µm can be mass-produced at a high yield in a stable manner and requiring less quality control). It is also preferable, for example, to give two uniform treatments on the entire surface of the gear member by means of buffing, etc., to produce a gear member having a surface roughness (Ra) in a range of 0.30 µm or less but not below 0.10 µm over its entire surface.

The inventors plotted the data obtained by a series of prototypes described above on a single graph. To their surprise, the plot provided a regression expression independent of materials. Further, this regression expression was very reliable and offered extremely high utility in practical applications (refer to Fig. 4 wherein a TiO2 film having a thickness of 200 nm and a SiO2 film having a thickness of 20 nm were formed as the photocatalytic film and the hydrophilic film, and the substrate was heated to temperatures of 300°C or above but not exceeding 450°C).

It was also found that, to achieve this regression expression, surface roughness is measured preferably in a large area of 100 µm x 100 µm to the order of µm using a laser microscope. This conclusion is based on a finding that the measured surface roughness would vary significantly depending on the measuring method (measuring equipment) and size of measured area.

For example, surface roughness is generally measured using an interatomic-force microscope in the production of photocatalytic film on exterior automotive mirrors, etc. If the member itself requires a surface roughness of 100 nm or less, or preferably 50 nm or less, in order to satisfy its own characteristic requirement, measuring surface roughness in a small area to the order of nm will make it difficult to achieve the aforementioned regression expression. This conclusion is based on a finding that even when surface roughness was measured by a laser microscope, if the measured area was small, such as 10 µm x 10 µm, achieving the above regression expression would become difficult. According to another finding by the inventors, if the member does not require a surface roughness of 100 nm or less, or preferably 50 nm or less, in order to satisfy its own characteristic requirement, its arithmetic-average surface roughness (Ra) must be measured in an area of 100 µm x 100 µm by a laser microscope in order to achieve the above regression expression. In other words, the Ra, or arithmetic-average surface roughness, of a 100 µm x 100 µm area as measured by a laser microscope had a highly reliable correlation with photocatalytic performance regardless of the material.

Achieving the above regression expression with a small measured area is difficult because, in the case of a part that does not require a surface roughness of 100 nm or less, or preferably 50 nm or less, in order to satisfy its own characteristic requirement, the surface area measured in a small area of 10 µm x 10 µm or less will have one more digit compared with the surface roughness measured in a large area of 100 µm x 100 µm or less. In addition, with such a part the surface roughness measured in a small area of 10 µm x 10 µm or less has no correlation with photocatalytic performance.

However, the above is simply the definition of Ra and is not intended to impose any limitation on arithmetic-average surface roughness when measured in a different area or by a different method.

The utility and patentability of the know-how of the present invention described above are not dependent on the material used (metal members, resin members, ceramic members, etc.), and desired photocatalytic performance can be obtained accurately (manifestation and level of photocatalytic performance can be accurately predicted before formation of film) by adjusting the surface roughness of each material to the range specified by the present invention using a method appropriate for the material and by considering desired photocatalytic performance, associated cost increase and so on.

Simple formation of film without utilizing the aforementioned know-how often results in an insufficient effect and, as mentioned above, the level of photocatalytic performance tends to vary significantly depending on the slight difference in surface roughness. As a result, sufficient photocatalytic action may or may not be achieved depending on manufacturing variation or quality variation. Particularly with a member that does not require a specific level of surface roughness in order to satisfy its own characteristic requirement, simple formation of film on the member does not yield the desired effect. Even if the desired effect is obtained by luck, such result is only temporary because surface roughness is not normally controlled, or a specific level of surface roughness may or may not be obtained (i.e., the desired effect may or may not be achieved) depending on manufacturing variation or quality variation, in the case of a member that does not require a specific level of surface roughness in order to satisfy its own characteristic requirement.

Without the aforementioned know-how, trial and error is inevitable. Even if a desired effect is achieved after many attempts of trial and error, the obtained surface roughness may prove unnecessary (in cases where the arithmetic-average surface roughness (Ra) is specified to a several nm order (10 nm or less), for example), in which case the whole exercise will be dismissed as a waste of money. Particularly with a member that does not require a specific level of surface roughness in order to satisfy its own characteristic requirement, unnecessary pursuit of surface roughness (such as specifying the arithmetic-average surface roughness (Ra) to a several nm order (10 nm or less)) will only increase cost without offering a meaningful justification and the obtained specification may not be feasible due to cost concerns.

At least one embodiment of the present invention provides a member that accurately exhibits a desired level of photocatalytic performance by way of adjusting the surface roughness of the member to the range specified by the present invention using a method appropriate for the material of the member and in consideration of desired photocatalytic performance, associated cost increase, and so on.

The present invention includes, but is not limited to, the following embodiments:

### (Structure 1)

In relation to a member that does not conventionally guarantee manifestation of actual photocatalytic action and benefits therefrom when photocatalytic film and hydrophilic film are simply formed in layers in this order on the surface of the member using the deposition method, sputter method or CVD method;

a member of the same shape and having the same purpose as the aforementioned member;

the member being produced in such a way that the surface of the member is adjusted to an arithmetic-average surface roughness (Ra) of 0.78 µm or less as measured in an area of 100 µm x 100 µm by a laser microscope and then photocatalytic film and hydrophilic film are formed in layers in this order on the aforementioned surface using the deposition method, sputter method or CVD method.

This structure allows for production of a member that accurately exhibits a desired level of photocatalytic performance by way of adjusting the surface roughness of the member precisely to the range specified by the present invention using a method appropriate for the material of the member and in consideration of desired photocatalytic performance, associated cost increase, and so on, even when the applicable member is one that does not conventionally guarantee manifestation of actual photocatalytic action and benefits therefrom by simply forming photocatalytic film and hydrophilic film in layers in this order on the surface of the member using the deposition method, sputter method or CVD method.

The minimum arithmetic-average surface roughness (Ra) as measured in an area of 100 µm x 100 µm by a laser microscope is 0.01 µm, which is the minimum resolution of the laser microscope in the height direction. However, it can be set to 0.09 µm if higher photocatalytic performance is required, or to 0.08 µm, 0.07 µm, 0.06 µm or 0.05 µm if higher photocatalytic performance is required together with stability of such performance, or to 0.11 µm, 0.12 µm, 0.15 µm or 0.20 µm if higher photocatalytic performance is required while any cost increase must be kept to a minimum.

In Structure 1 as explained above, the material of "a member of the same shape and having the same purpose as the aforementioned member" may be the same as the material of a member that does not conventionally guarantee manifestation of actual photocatalytic action and benefits therefrom by simply forming photocatalytic film and hydrophilic film in layers in this order on the surface of the member using the deposition method-as long as the entire surface of the substrate can be treated to a nearly uniform surface roughness at low cost. If not, however, it is desirable to use a material that allows the entire surface of the substrate to be treated to a nearly uniform surface roughness at low cost.

### (Structure 2)

A camera having a camera lens or hood glass having a surface exposed to the external environment, and a member for retaining the aforementioned camera lens or hood glass installed on the outer periphery of the aforementioned camera lens or hood glass, characterized in that:

photocatalytic film and hydrophilic film are formed in layers in this order using the deposition method, sputter method or CVD method on the surface of the camera lens or hood glass having a surface exposed to the external environment; and

the surface of the aforementioned retention member is produced in such a way that the arithmetic-average surface roughness (Ra) of the surface as measured in an area of 100 µm x 100 µm by a laser microscope becomes 0.78 µm or less and that photocatalytic film and hydrophilic film are formed in layers in this order using the deposition method, sputter method or CVD method on at least the surface of the retention member contacting the aforementioned camera lens or hood glass.

This structure allows for production of a retention member for camera lens or hood glass that accurately exhibits a desired level of photocatalytic performance by way of adjusting the surface roughness of the member precisely to the range specified by the present invention using a method appropriate for the material of the member and in consideration of desired photocatalytic performance, associated cost increase, and so on.

In Structure 2 as explained above, a level of photocatalytic performance considered sufficient and prominent in practical applications can be accurately added to and manifested in the retention member. This way, the problem of a deteriorating field of view resulting from water droplets collecting between the retention member and camera lens, etc., can be eliminated for a longer period of time-especially through the interaction of films formed on both parts that can retain the same performance for a long period of time (films that are formed under equivalent conditions and possess equivalent performance).

Incidentally, the arithmetic-average surface roughness (Ra) of the camera lens or hood glass as measured in an area of 100 µm x 100 µm by a laser microscope was 0.05 µm or less.

In Structure 2 as explained above, photocatalytic film and hydrophilic film can be formed in layers in this order also on the entire surface of the part exposed to the external environment, of the surface of the aforementioned retention member for the camera lens or hood glass (for example, the retention surface (2a) and side face (2b) of the retainer (2) for the lens (1) as shown in Fig. 5). This prevents the water droplets collecting on the side face (3b) of the retention member from flowing down onto the lens and temporarily reducing the field of view. Similarly under the present invention, photocatalytic film and hydrophilic film can be formed in layers in this order also on the surface of the camera case member having a surface exposed to the external environment (for example, the side face (3a) and back face (3b) of the case (3) for the camera (10) as shown in Fig. 5). This prevents the water droplets collecting on the case member surface from flowing down onto the lens and temporarily reducing the field of view.

### (Structure 3)

In relation to a bicycle part that does not conventionally guarantee manifestation of actual photocatalytic action and benefits therefrom when photocatalytic film and hydrophilic film are simply formed in layers in this order on the surface of the member using the deposition method, sputter method or CVD method;

a bicycle part of the same shape and having the same purpose as the aforementioned bicycle part;

the bicycle part being produced in such a way that the surface of the aforementioned bicycle part is adjusted to an arithmetic-average surface roughness (Ra) of 0.78 µm or less as measured in an area of 100 µm x 100 µm by a laser microscope and then photocatalytic film and hydrophilic film are formed in layers in this order on the aforementioned surface using the deposition method, sputter method or CVD method.

This structure allows for production of a bicycle part that accurately exhibits a desired level of photocatalytic performance by way of adjusting the surface roughness of the bicycle part precisely to the range specified by the present invention using a method appropriate for the material of the bicycle part and in consideration of desired photocatalytic performance, associated cost increase, and so on, even when the applicable bicycle part is one that does not conventionally guarantee manifestation of actual photocatalytic action and benefits therefrom by simply forming photocatalytic film and hydrophilic film in layers in this order on the surface of the part using the deposition method, sputter method or CVD method.

The present invention according to Structure 3 as explained above can be used favorably on gears, disk brake rotors, hubs, or spokes, nipples and other parts near hubs, i.e., those bicycle parts to which oil attaches easily.

In addition to bicycle parts, the present invention according to Structure 3 as explained above can be used favorably on aluminum wheels for automotive tires, etc., that are also subject to attachment of oil, etc.

### (Structure 4)

A laser radar device having a laser radar unit, and a laser radar cover member having a surface exposed to the external environment, characterized in that:

the laser radar cover member is a polyimide resin molding; and

photocatalytic film and hydrophilic film are formed in layers in this order using the deposition method, sputter method or CVD method on the surface of the aforementioned laser radar cover member that has been produced in such a way that the surface has an arithmetic-average surface roughness (Ra) of 0.78 µm or less as measured in an area of 100 µm x 100 µm by a laser microscope.

This structure allows for production of a laser radar cover member that accurately exhibits a desired level of photocatalytic performance by way of adjusting the surface roughness of the laser radar cover member precisely to the range specified by the present invention using a method appropriate for the material of the member and in consideration of desired photocatalytic performance, associated cost increase, and so on.

In the present invention according to Structure 4 as explained above, photocatalytic film and hydrophilic film can be formed in layers in this order also on the surface of another member contacting the laser radar cover member or located adjacent to the laser radar cover member. This prevents the water droplets collecting on the surface of any such contacting/adjacent member from flowing down onto the laser radar cover member and temporarily reducing the radar sensitivity.

Polyimide resin is most desirable as the cover material for laser radars installed on vehicles, etc., for its smoothness and heat resistance, among others. Acrylic resin is the second best choice.

The present invention according to Structure 4 as explained above can also be applied to the cover members for laser radars installed on trains and various other mobile objects.

### (Structure 5)

In relation to a member that does not conventionally guarantee manifestation of actual photocatalytic action and benefits therefrom when photocatalytic film and hydrophilic film are simply formed in layers in this order on the surface of the member using the deposition method, sputter method or CVD method;

a method of producing a member of the same shape and having the same purpose as the aforementioned member that manifests actual photocatalytic action and benefits therefrom, comprising the steps of:

producing the member in such a way that its arithmetic-average surface roughness (Ra) is adjusted to 0.78 µm or less as measured in an area of 100 µm x 100 µm by a laser microscope; and

forming photocatalytic film and hydrophilic film in layers in this order on the surface of this member using the deposition method, sputter method or CVD method.

The invention according to Structure 5 as explained above allows for production of a member that accurately exhibits a desired level of photocatalytic performance by way of adjusting the surface roughness of the member precisely to the range specified by the present invention using a method appropriate for the material of the member and in consideration of desired photocatalytic performance, associated cost increase, and so on, even when the applicable member is one that does not conventionally guarantee manifestation of actual photocatalytic action and benefits therefrom by simply forming photocatalytic film and hydrophilic film in layers in this order on the surface of the member using the deposition method, sputter method or CVD method. By producing a member beforehand whose surface roughness is adjusted precisely to the range specified by the present invention, achievement of a desired level of photocatalytic performance can be accurately predicted.

### (Structure 6)

In relation to a member that does not conventionally guarantee manifestation of actual photocatalytic action and benefits therefrom when photocatalytic film and hydrophilic film are simply formed in layers in this order on the surface of the member using the deposition method, sputter method or CVD method;

a method of producing a member of the same shape and having the same purpose as the aforementioned member that manifests actual photocatalytic action and benefits therefrom, comprising the steps of:

preparing various substrates of an identical material or different materials, each having a different surface roughness level (by a range of approx. 2 µm or less, for example), measuring their arithmetic-average surface roughness (Ra) in an area of 100 µm x 100 µm by a laser microscope, and then forming photocatalytic film and hydrophilic film (TiO₂ porous SiO₂ in layers in this order on the surfaces of the aforementioned various substrates using the deposition method, sputter method or CVD method (the substrate is heated to temperatures of 300°C or above but not exceeding 450°C in the case of the deposition method or CVD method, or to temperatures of 150°C or above but not exceeding 450°C in the case of the sputter method) to produce samples;

applying engine oil on each sample as produced above, letting the sample stand for one hour in an ambience of 20°C in temperature and 50% in relative humidity, and then wiping off oil using cotton so that the water-droplet contact angle becomes 60° to 70°;

irradiating each sample for 24 hours under a black light with an intensity of 1.0 mW/cm² to measure the water-droplet contact angle;

obtaining the relationship in the form of a regression line or regression expression or both between the arithmetic-average surface roughness (Ra) of each substrate as measured in an area of 100 µm x 100 µm by a laser microscope and the water-droplet contact angle of the corresponding sample as measured after the sample was irradiated for 24 hours under a black light with an intensity of 1.0 mW/cm² (the coefficient of determination, R₂, in the above regression expression should preferably be closer to 1.0000 than to 0.9900);

determining a desired surface roughness range for the aforementioned members based on the aforementioned regression line or regression expression or both;

producing a member having a surface roughness in the range determined above (range specified by the present invention) according to the aforementioned member material; and

forming photocatalytic film and hydrophilic film in layers in this order on the surface of this member using the deposition method, sputter method or CVD method to produce a member that accurately exhibits desired photocatalytic performance.

The invention according to Structure 6 as explained above provides a production method for members that accurately exhibit desired photocatalytic performance.

### (Structure 7)

A method of producing a member as described in Claim 6; wherein the aforementioned surface roughness range of member as determined on the basis of the aforementioned regression line, regression expression or both and in consideration of desired photocatalytic performance and associated cost increase is 0.78 µm or less based on arithmetic-average surface roughness (Ra).

The invention according to Structure 7 as explained above allows for accurate production of members that can actually manifest photocatalytic action sufficiently and prominently by way of adjusting their surface roughness to the range specified by the present invention.

### (Structure 8)

A method of producing a member as described in Claim 6 or 7; wherein the surface roughness of all or some of the aforementioned members before film formation is measured in an area of 100 µm x 100 µm by a laser microscope and only those members whose surface roughness is inside the range that was predetermined in consideration of desired photocatalytic performance and associated cost increase (range specified by the present invention) are selected, and then photocatalytic film and hydrophilic film are formed in layers in this order on the selected members (by eliminating members whose surface roughness is outside the range specified by the present invention).

The invention according to Structure 8 as specified above ensures excellent productivity and high yield in mass production, because a preliminary inspection is conducted on all of the aforementioned members before film formation so that film is formed only on those members whose surface roughness is inside the predetermined range (range specified by the present invention) (by eliminating members whose surface roughness is outside the range specified by the present invention), thereby allowing the total quantity to properly manifest desired photocatalytic performance.

Even when only some of the aforementioned members before film formation are inspected (by sampling inspection), a method (processing method) for ensuring that the total quantity will have a surface roughness inside the specified range (sampling inspection is sufficient in this case) or a method (processing method) for ensuring that, among the total quantity, a quantity needed to make mass production feasible will have a surface roughness inside the specified range (100% inspection after film formation is desirable in this case) can be identified in advance. These methods can help assure achievement of desired photocatalytic performance, identify problems in the manufacturing process, and also improve productivity and yield in mass production.

The measuring method using a laser microscope, which is used in each of the aforementioned variations of the present invention, can inspect members before film formation without damaging or contacting the members. Also, all products on the line can be inspected, or a part of them can be sampled for inspection, using a laser microscope. These features make a laser microscope very useful in the application of the present invention. On the other hand, an interatomic-force microscope requires samples to be cut out prior to measurement. These samples are also contacted by the probe, which necessitates a complex measuring procedure. The samples that have been measured are deemed damaged or unduly contacted and therefore cannot be used as products. Of course, 100% inspection is unfeasible using an interatomic-force microscope, so the products on the line cannot be controlled easily using this microscope.

In each of the aforementioned variations of the present invention, it is desirable that the arithmetic-average surface roughness (Ra) of the member before film formation, as measured in an area of 100 µm x 100 µm by a laser microscope, conform to the surface roughness specified above over the entire surface of the aforementioned member or entire surface in the area that requires photocatalytic performance.

In each of the aforementioned variations of the present invention, it is also desirable that the arithmetic-average surface roughness (Ra) of the member before film formation, as measured in an area of 100 µm x 100 µm by a laser microscope, conform to the surface roughness specified above at a minimum of 3 points, or more preferably at 5 points or 10 points, or most preferably at 20 points, on the entire surface of the aforementioned member. If the surface roughness specified above is satisfied at 10 or more points on the surface of the aforementioned member, it can be expected that desired photocatalytic performance will manifest over the entire surface of the aforementioned member or entire surface in the area that requires photocatalytic performance.

An embodiment of the present invention is particularly useful on members with a non-flat or curved shape (especially members with a curved shape that makes it difficult to obtain a uniform surface roughness), members with a complex shape, and other members where achievement of a uniform surface roughness is difficult.

An embodiment of the present invention is particularly useful on members where achievement of a uniform surface roughness is difficult. On these members, pursuit of surface roughness can reduce yield and affect productivity, while such effort may also require complex quality control procedures. On these members, it makes sense to keep their surface roughness at a level near the upper limit cost wise.

An embodiment of the present invention is particularly useful on members that do not require surface roughness control as their own characteristic requirement and strict control of surface roughness is technically difficult. On these members, the level of surface roughness that can be pursued is limited by cost, so it makes sense to keep their surface roughness at a level near 0.09 µm, which is the lower limit cost wise. If the level of surface roughness that can be pursued is limited by cost and keeping to the budgeted cost is particularly important, it makes sense to keep the surface roughness of the member before film formation to a level near the lower limit of 0.10 µm. It may also make sense to keep the surface roughness to a level near the lower limit of 0.15 µm, or even near the lower limit of 0.20 µm.

In each of the aforementioned variations of the present invention, it is desirable that the aforementioned hydrophilic film comprises SiO₂ film and the aforementioned photocatalytic film comprises TiO₂ film. This is because SiO₂ film is an oxide film and easily generates the OH group, which is a hydrophilic group and contributes to good hydrophilicity. In addition, the refractive index of SiO₂ film is lower than that of glass plate and close to the refractive indexes of water and air. This keeps refractions on the SiO₂ film surface to a minimum, which in turn prevents generation of double images. As a result, SiO₂ film causes minimal diffused reflection even when raindrops attach to the surface, thus ensuring good visibility through the surface on which the film is applied. Furthermore, SiO₂ film is an inorganic material and thus offers high scratch resistance and heat resistance and provides excellent durability and weather resistance. As the hydrophilic film, Al₂O₃ film, TiO₂ film or other oxide films can be used instead of SiO₂ film. As the photocatalytic film, SrTiO₃ film or KNbO₃ film can be used in stead of TiO₂ film.

In each of the aforementioned variations of the present invention, both the photocatalytic film and hydrophilic film may be formed using the same method selected from the deposition method, sputter method and CVD method, or each film may be formed using a different method selected from the same group specified above.

The thickness of a photocatalytic film such as a TiO₂ film may be about 50 nm to about 400 nm (preferably 100 nm to 300 nm), and the thickness of a hydrophilic film such as a SiO₂ film may be about 1 nm to about 400 nm (preferably 10 nm to 100 nm). Further, in an embodiment, each film can be constituted by multiple layers. Additionally, in an embodiment, the surface on which the photocatalytic film is formed can coated with another layer or a undercoating prior to deposition of the photocatalytic film.

In each of the aforementioned variations of the present invention, it is desirable that the surface of the aforementioned hydrophilic film have a porous structure. This is because if the hydrophilic film comprising SiO₂ film has a porous surface, wettability will improve due to the capillary effect and this will in turn enhance hydrophilicity and consequently increase the effect of removing water droplets. Furthermore, the pores (gaps) in SiO₂ film will also facilitate the decomposition of soiling and other foreign material in the photocatalytic layer underneath.

In each of the aforementioned variations of the present invention, it is desirable for a member that should not generate interference colors to incorporate a material having a refractive index between that of TiO₂ and that of the substrate, such as ITO, SnO₂, Ta₂O₅, ZiO₂, WO₃ or Al₂O₃, between TiO₂ and the substrate and then have SiO₂ on top (in the laminated structure of the substrate/the material with an intermediate refractive index/TiO₂/SiO₂), in order to suppress generation of interference colors of TiO₂. Members that can benefit from this measure include retention members for camera lenses, etc., installed on the outer periphery of the camera lens, etc., (these peripheral members are called "retainer") and cover members for laser radars.

In each of the aforementioned variations of the present invention, the applicable member may be made of any of the following materials:
1) Stainless steel, cold-rolled steel sheet, aluminum, alumite, iron, nickel, titanium, brass and other metals.
2) Polyimide, ABS (polyacrylonitrile butadiene styrene resin), PP (polypropylene), PE (polyethylene), PS (polystyrene), PMMA (acrylic), PET (polyethylene terephthalate), PPE (polyphenylene ether), PA (nylon/polyamide), PC (polycarbonate), POM (polyacetal), PBT (polybutylene terephthalate), PPS (polyphenylene sulfide), PEEK (polyether etherketone), LCP (liquid crystal polymer), fluororesin, urethane resin, elastomer and other resins.
3) Glass, ceramics, Zeonex™ (polyolefin; manufactured by Zeon Corporation), etc.

The foregoing explained embodiments of the present invention. Note that the technical scope of the present invention is not limited to the embodiments explained above. It is apparent to those skilled in the art that various modifications and/or improvements can be added to the aforementioned embodiments. It is clear from the descriptions under "Scope of Claims" that such other embodiments that incorporate modifications and/or improvements are also included in the technical scope of the present invention.

Examples of the present invention are explained below.

### (Example 1)

As shown in Fig. 3, arithmetic-average surface roughness (Ra) was measured in an area of 100 µm x 100 µm by a laser microscope (VK-8510 ultra-depth shape measuring microscope manufactured by Keyence Corporation) on various samples each having a different surface roughness level, and then TiO₂ and SiO₂ were formed on the respective samples by 200 nm and 20 nm, respectively. The substrate was heated to temperatures of 300°C or above but not exceeding 450°C.

Next, engine oil was applied on the produced samples, after which the samples were let stand for one hour in an ambience of 20°C in temperature and 50% in relative humidity, and then oil was wiped off using cotton to adjust the water-droplet contact angle to approx. 60° to 70°, in order to determine the photocatalytic property and hydrophilicity (anti-fogging property) of the samples. Next, the samples were irradiated for 24 hours under a black light with an intensity of 1.0 mW/cm² (equivalent to an average quantity of ultraviolet light the candidate products are exposed to in a day), after which the water-droplet contact angle was measured. UV intensity was measured using a UV intensity meter manufactured by Topcon Corporation, while water-droplet contact angle was measured with the contact-angle measuring system manufactured by Kyowa Interface Science Co., Ltd. FL20S/BL-B manufactured by Matsushita Electric Industrial Co., Ltd. was used as the black light.

Figs. 3 and 4 show the relationships of the arithmetic-average surface roughness (Ra) of substrate before film formation and the water-droplet contact angle after exposure to 1.0 mW/cm² of UV light for 24 hours. A regression line and a regression expression representing these relationships were obtained. The coefficient of determination, R², in this regression expression was 0.9988 (very close to 1.0000), indicating high reliability of the expression.

From the regression expression obtained from Fig. 4 (y = 27.773x - 1.7543), the arithmetic-average surface roughness (Ra) at which the water-droplet contact angle becomes 20°, a level at which hydrophilicity is roughly confirmed, is calculated as approx. 0.78 µm. This suggests that, if Ra is given as 0.78 µm or less, excellent photocatalytic property and hydrophilicity (anti-fogging property) can be obtained.

In Example 1 as explained above, the same tests were conducted with the sputter method and CVD method (the substrate was heated to temperatures of 300°C or above but not exceeding 450°C in the case of the CVD method, and to temperatures of 150°C or above but not exceeding 450°C in the case of the sputter method), in addition to using the deposition method. Similar results were obtained from the tests using the other two methods.

Based on the know-how obtained from the aforementioned regression line and regression expression, photocatalytic film and hydrophilic film were formed in layers in this order, using the deposition method, sputter method or CVD method, on the surfaces of retainers (camera-lens retention members), laser radar cover members made of resin, and bicycle gear members, which were all produced in such a way that the arithmetic-average surface roughness (Ra) as measured in an area of 100 µm x 100 µm by a laser microscope became 0.78 µm or less. When the same tests as described in Example 1 above were conducted on these samples, the achieved water-droplet contact angles were 20° or less, indicating excellent photocatalytic property and hydrophilicity (anti-defogging property).

### (Example 2)

Check of adhesive strength

A tape peel test was conducted on the samples produced in Example 1, in order to check the adhesive strength of the samples.

Specifically, a piece of Cellotape (trademark) No. 405 manufactured by Nichiban Co., Ltd. was attached on the substrate, after which one end of the tape was held at right angles to the test piece and then pulled up in order to determine whether or not the film would peel off, as a measure of the film's adhesive strength.

As a result, none of the samples exhibited peeled film, confirming good adhesive strength.

### (Example 3)

Effectiveness of the present invention on an anti-fogging element or similar member, whose arithmetic-average surface roughness (Ra) of the substrate surface is 0.78 µm or less and which also had an anti-fogging film formed on its substrate surface, was confirmed.

As the aforementioned anti-fogging film, a single-layer TiO₂ film, a double-layer film comprising TiO₂ and SiO₂ stacked on top of each other, and a multi-layer film comprising a material having a refractive index between TiO₂ and the substrate, such as ITO, SnO₂, Ta₂O₅ ZiO₂, WO₃ or Al₂O₃, inserted between TiO₂ and the substrate and also having SiO₂ formed on top in order to suppress generation of interference colors of TiO₂, were used. As a result, each of these samples with an anti-fogging film exhibited an excellent anti-defogging effect sufficient in practical applications-a level higher than what was measured on members having an arithmetic-average surface roughness (Ra) of over 0.78 µm on their substrate.

Industrial Field of Application

The present invention can be suitably used in various applications-particularly on retention members for camera lenses and hood glasses that are used in cameras installed in high places as surveillance cameras or in other outdoor locations where maintenance is difficult.

In addition, the present invention is particularly suited on bicycle gears and disc brake rotors to which oil attaches easily.

Furthermore, the present invention is particularly suited on cover materials for laser radars used for the purpose, among others, of measuring the distance between the subject vehicle and preceding vehicle to control the speed of the subject vehicle accordingly.

## Claims

1. An article comprising:
a) a surface
wherein the material of said surface is selected from the group of stainless steel, cold-rolled steel sheet, aluminum, alumite, iron,nickel, titanium, brass; polyimide, ABS (polyacrylonitrile butadiene styrene resin), PP (polypropylene), PE (polyethylene), PS (polystyrene), PMMA (acrylic), PET (polyethylene terephthalate), PPE (polyphenylene ether), PA (nylon/polyamide), PC (polycarbonate), POM (polyacetal), PBT (polybutylene terephthalate), PPS (polyphenylene sulfide), PEEK (polyether etherketone), LCP (liquid crystal polymer), fluororesin, urethane resin, elastomer; glass, and ceramics,
wherein said surface has an arithmetic-average surface roughness (Ra) of 0.78 µm or less as measured in an area of 100 µm x 100 µm by a laser microscope;
b) a photocatalytic film deposited on the surface
wherein said photocatalytic film is constituted by TiO₂;
wherein the photocatalytic film of TiO₂ has a thickness from 50 to 400 nm; and
c) a hydrophilic film deposited on the photocatalytic film and exposed to the external environment
wherein the hydrophilic film is constituted by SiO₂,
wherein the hydrophilic film of SiO₂ has a thickness from 1 to 400 nm and has a porous structure.

2. The article according to claim 1, wherein the photocatalytic film and the hydrophilic film are films deposited by physical or chemical vapor deposition.

3. The article according to claim 1 or 2, wherein a surface of the hydrophilic film has a water-droplet contact angle of about 20° or less as measured after being irradiated for 24 hours with a black light having an intensity of 1.0 mW/cm².

4. The article according to any of claims 1 to 3, which is a camera comprising a camera lens or hood glass and a retainer retaining the camera lens or hood glass at its outer periphery, wherein the surface comprises a surface of the retainer.

5. The article according to claim 4, wherein the surface of the retainer has an Ra of 0.60-0.78 µm, and a surface of the hydrophilic film has a water-droplet contact angle of about 15° to about 20° as measured after being irradiated for 24 hours with a black light having an intensity of 1.0 mW/cm².

6. The article according to any of claims 1 to 3, which is a bicycle part, wherein the surface comprises a surface of the bicycle part.

7. The article according to any of claims 1 to 3, which is a laser radar device comprising a laser radar unit and a laser radar cover member, wherein the laser radar cover member is a polyimide resin molding, and the surface comprises a surface of the laser radar cover member.

8. The article according to claim 7, wherein the surface of the laser radar cover member has an Ra of 0.2 µm or less, and a surface of the hydrophilic film has a water-droplet contact angle of about 4° or less as measured after being irradiated for 24 hours with a black light having an intensity of 1.0 mW/cm².

9. A method of producing an article manifesting photocatalytic action, comprising:
i) determining an area of an article, which is to manifest photocatalytic action wherein the material of said area of an article is selected from the group of stainless steel, cold-rolled steel sheet, aluminum, alumite, iron,nickel, titanium, brass; polyimide, ABS (polyacrylonitrile butadiene styrene resin), PP (polypropylene), PE (polyethylene), PS (polystyrene), PMMA (acrylic), PET (polyethylene terephthalate), PPE (polyphenylene ether), PA (nylon/polyamide), PC (polycarbonate), POM (polyacetal), PBT (polybutylene terephthalate), PPS (polyphenylene sulfide), PEEK (polyether etherketone), LCP (liquid crystal polymer), fluororesin, urethane resin, elastomer; glass, and ceramics;
ii) determining whether the area has an arithmetic-average surface roughness (Ra) of 0.78 µm or less as measured in an area of 100 µm x 100 µm by a laser microscope;
iii) if Ra is more than 0.78 µm, adjusting the Ra to 0.78 µm or less;
iv) forming a photocatalytic film on the area by physical or chemical vapor deposition
wherein the photocatalytic film is constituted by TiO₂;
wherein the photocatalytic film of TiO₂ has a thickness from 50 to 400 nm, and
v) forming a hydrophilic film on the photocatalytic film by physical or chemical vapor deposition
wherein the hydrophilic film is constituted by SiO₂,
wherein the hydrophilic film of SiO₂ has a thickness from 1 to 400 nm and has a porous structure.

10. The method according to claim 9, wherein a surface of the hydrophilic film has a water-droplet contact angle of about 20° or less as measured after being irradiated for 24 hours with a black light having an intensity of 1.0 mW/cm².

11. The method according to claim 9 or 10, wherein the article is a camera comprising a camera lens or hood glass and a retainer retaining the camera lens or hood glass at its outer periphery, wherein the area comprises a surface of the retainer.

12. The method according to claim 11, wherein the step of adjusting the Ra comprises adjusting the Ra to 0.60-0.78 µm, wherein a surface of the hydrophilic film has a water-droplet contact angle of about 15° to about 20° as measured after being irradiated for 24 hours with a black light having an intensity of 1.0 mW/cm².

13. The method according to claim 9 or 10, wherein the article is a bicycle part, wherein the area comprises a surface of the bicycle part.

14. The method according to claim 9 or 10, wherein the article is a laser radar device comprising a laser radar unit and a laser radar cover member, wherein the laser radar cover member is a polyimide resin molding, and the surface comprises a surface of the laser radar cover member.

15. The method according to claim 14, wherein the step of adjusting the Ra comprises adjusting the Ra to 0.2 µm or less, wherein a surface of the hydrophilic film has a water-droplet contact angle of about 4° or less as measured after being irradiated for 24 hours with a black light having an intensity of 1.0 mW/cm².

16. A method of producing an article manifesting photocatalytic action, comprising:
i) obtaining a regression line or regression expression or both of a relationship between arithmetic-average surface roughness (Ra) of a surface of an article as measured in an area of 100 µm x 100 µm by a laser microscope and a water-droplet contact angle (Ca) of a top surface of the article as measured after being irradiated for 24 hours with a black light having an intensity of 1.0 mW/cm², wherein a photocatalytic film and a hydrophilic film are formed in sequence on the surface by physical or chemical vapor deposition under a given condition;
ii) selecting an article-to-be-treated;
iii) determining a desired Ca of an area of the article;
iv) determining a desired Ra of the area which is 0.78 µm or less for the desired Ca based on the regression line or regression expression or both;
v) processing the area to adjusting its Ra to the desired Ra,
vi) forming a photocatalytic film and a hydrophilic film in sequence on the area by physical or chemical vapor deposition under the given condition;
wherein the material of said surface of an article is selected from the group of stainless steel, cold-rolled steel sheet, aluminum, alumite, iron,nickel, titanium, brass; polyimide, ABS (polyacrylonitrile butadiene styrene resin), PP (polypropylene), PE (polyethylene), PS (polystyrene), PMMA (acrylic), PET (polyethylene terephthalate), PPE (polyphenylene ether), PA (nylon/polyamide), PC (polycarbonate), POM (polyacetal), PBT (polybutylene terephthalate), PPS (polyphenylene sulfide), PEEK (polyether etherketone), LCP (liquid crystal polymer), fluororesin, urethane resin, elastomer; glass, and ceramics;
wherein the photocatalytic film is constituted by TiO₂;
wherein the photocatalytic film of TiO₂ has a thickness from 50 to 400 nm, and
wherein the hydrophilic film has a porous structure and is constituted by SiO₂,
wherein the hydrophilic film of SiO₂ has a thickness from 1 to 400 nm and has a porous structure.

17. The method according to claim 16, wherein the step of obtaining the regression line or regression expression or both uses different articles made of different materials.

18. The method according to claim 16, wherein a surface of the hydrophilic film has a Ca of about 20° or less.

## Patentansprüche

1. Artikel, umfassend:
a) eine Oberfläche,
wobei das Material der Oberfläche ausgewählt ist aus der Gruppe aus Edelstahl, kalt gewalztem Stahlblatt, Aluminium, Aluminiumoxid (alumite), Eisen, Nickel, Titan, Messing; Polyimid, ABS (Polyacrylnitril-Butadien-Styrol-Harz), PP (Polypropylen), PE (Polyethylen), PS (Polysterol), PMMA (Acryl), PET (Polyethylenterephthalat), PPE (Polyphenylenether), PA (Nylon/Polyamid), PC (Polycarbonat), POM (Polyacetal), PBT (Polybutylenterephthalat), PPS (Polyphenylensulfid), PEEK (Polyetheretherketon), LCP (Flüssigkristall-Polymer), Fluorharz, Urethan-Harz, Elastomer; Glas und Keramik,
wobei die Oberfläche eine arithmetische Durchschnitts-Oberfächenrauheit (Ra) von 0,78 µm oder weniger aufweist, wie auf einer Fläche von 100 µm x 100 µm mittels eines Lasermikroskops gemessen;
b) einen fotokatalytischen Film, der auf der Oberfläche abgelagert wurde,
wobei der fotokatalytische Film aus TiO₂ gebildet wird;
wobei der fotokatalytische Film aus TiO₂ eine Dicke von 50 bis 400 nm aufweist; und
c) einen hydrophilen Film, der auf dem fotokatalytischen Film abgelagert wurde und der äußeren Umgebung ausgesetzt wurde,
wobei der hydrophile Film aus SiO₂ gebildet,
wobei der hydrophile Film aus SiO₂ eine Dicke von 1 bis 400 nm aufweist und eine poröse Struktur hat.

2. Artikel gemäß Anspruch 1, wobei der fotokatalytische Film und der hydrophile Film Filme sind, die mittels physikalischer und chemischer Gasphasenabscheidung abgelagert wurden.

3. Artikel gemäß Anspruch 1 oder 2, wobei eine Oberfläche des hydrophilen Filmes einen Wassertröpfchen-Kontaktwinkel von ungefähr 20° oder weniger aufweist, wie nach Bestrahlung für 24 Stunden mit einem Schwarzlicht, das eine Intensität von 1,0 mW/cm² aufweist, gemessen.

4. Artikel gemäß einem der Ansprüche 1 bis 3, welcher eine Kamera ist, umfassend eine Kameralinse oder Abdeckhaubenglas und eine Aufnahme, die die Kameralinse oder Abdeckhaubenglas an ihrer äußeren Peripherie aufnimmt, wobei die Oberfläche eine Oberfläche der Aufnahme umfasst.

5. Artikel gemäß Anspruch 4, wobei die Oberfläche der Aufnahme eine Ra von 0,60-0,78 µm aufweist und eine Oberfläche des hydrophilen Filmes einen Wassertröpfchen-Kontaktwinkel von ungefähr 15° bis ungefähr 20° aufweist, wie nach Bestrahlung für 24 Stunden mit einem Schwarzlicht, das eine Intensität von 1,0 mW/cm² aufweist, gemessen.

6. Artikel gemäß einem der Ansprüche 1 bis 3, welcher ein Fahrradteil ist, wobei die Oberfläche eine Oberfläche des Fahrradteiles umfasst.

7. Artikel nach einem der Ansprüche 1 bis 3, welcher eine Laser-Radar-Vorrichtung ist, umfassend eine Laser-Radar-Einheit und ein Laser-Radar-Abdeckungsteil, wobei das Laser-Radar-Abdeckungsteil ein Polyimid-Harz-Formteil ist, und die Oberfläche eine Oberfläche des Laser-Radar-Abdeckungsteils umfasst.

8. Artikel gemäß Anspruch 7, wobei die Oberfläche des Laser-Radar-Abdeckungsteils eine Ra von 0,2 µm oder weniger aufweist und eine Oberfläche des hydrophilen Films einen Wassertröpfchen-Kontaktwinkel von ungefähr 4° oder weniger aufweist, wie nach Bestrahlung für 24 Stunden mit einem Schwarzlicht, das eine Intensität von 1,0 mW/cm² aufweist, gemessen.

9. Verfahren zur Produktion eines Artikels, der fotokatalytische Aktion manifestiert, umfassend:
i) Bestimmen eines Gebietes auf einem Artikel, welcher fotokatalytische Aktion manifestieren soll, wobei das Material des Gebietes eines Artikels ausgewählt ist aus der Gruppe bestehend aus Edelstahl, kalt gewalztem Stahlblatt, Aluminium, Aluminiumoxid (alumite), Eisen, Nickel, Titan, Messing; Polyimid, ABS (Polyacrylnitril-Butadien-Styrol-Harz), PP (Polypropylen), PE (Polyethylen), PS (Polysterol), PMMA (Acryl), PET (Polyethylenterephthalat), PPE (Polyphenylenether), PA (Nylon/Polyamid), PC (Polycarbonat), POM (Polyacetal), PBT (Polybutylenterephthalat), PPS (Polyphenylensulfid), PEEK (Polyetheretherketon), LCP (Flüssigkristall-Polymer), Fluorharz, Urethan-Harz, Elastomer; Glas und Keramik;
ii) Bestimmen, ob das Gebiet eine arithmetische Durchschnitts-Oberflächenrauheit (Ra) von 0,78 µm oder weniger aufweist, wie in einem Gebiet von 100 µm x 100 µm mittels eines Lasermikroskops gemessen;
iii) Wenn Ra mehr als 0,78 µm ist, Einstellen der Ra auf 0,78 µm oder weniger;
iv) Formen eines fotokatalytischen Films auf dem Gebiet mittels physikalischer oder chemischer Gasphasenabscheidung,
wobei der fotokatalytische Film aus TiO₂ gebildet wird;
wobei der fotokatalytische Film aus TiO₂ eine Dicke von 50 bis 400 nm aufweist, und
v) Bilden eines hydrophilen Films auf dem photokatalytischen Film mittels physikalischer oder chemischer Gasphasenabscheidung,
wobei der hydrophile Film aus SiO₂ gebildet wird,
wobei der hydrophile Film aus SiO₂ eine Dicke von 1 bis 400 nm aufweist und eine poröse Struktur hat.

10. Verfahren gemäß Anspruch 9, wobei eine Oberfläche des hydrophilen Filmes einen Wassertröpfchen-Kontaktwinkel von ungefähr 20° oder weniger aufweist, wie nach Bestrahlung für 24 Stunden mit einem Schwarzlicht, das eine Intensität von 1,0 mW/cm² aufweist, gemessen.

11. Verfahren gemäß Anspruch 9 oder 10, wobei der Artikel eine Kamera ist, umfassend eine Kameralinse oder Abdeckhaubenglas und eine Aufnahme, die die Kameralinse oder Abdeckhaubenglas an ihrer äußeren Peripherie aufnimmt, wobei die Oberfläche eine Oberfläche der Aufnahme umfasst.

12. Verfahren gemäß Anspruch 11, wobei der Schritt des Einstellens der Ra umfasst: Einstellen der Ra auf 0,60-0,78 µm, wobei eine Oberfläche des hydrophilen Films einen Wassertröpfchen-Kontaktwinkel von ungefähr 15° bis ungefähr 20° aufweist, wie nach Bestrahlung für 24 Stunden mit einem Schwarzlicht, das eine Intensität von 1,0 mw/cm² aufweist, gemessen.

13. Verfahren gemäß Anspruch 9 oder 10, wobei der Artikel ein Fahrradteil ist, wobei die Oberfläche eine Oberfläche des Fahrradteiles umfasst.

14. Verfahren gemäß Anspruch 9 oder 10, wobei der Artikel eine Laser-Radar-Vorrichtung ist, umfassend eine Laser-Radar-Einheit und ein Laser-Radar-Abdeckungsteil, wobei das Laser-Radar-Abdeckungsteil ein Polyimid-Harz-Formteil ist, und die Oberfläche eine Oberfläche des Laser-Radar-Abdeckungsteils umfasst.

15. Verfahren gemäß Anspruch 14, wobei der Schritt des Einstellens der Ra umfasst: Einstellen der Ra auf 0,2 µm oder weniger, wobei eine Oberfläche des hydrophilen Films einen Wassertröpfchen-Kontaktwinkel von ungefähr 4° oder weniger aufweist, wie nach Bestrahlung für 24 Stunden mit einem Schwarzlicht, das eine Intensität von 1,0 mW/cm² aufweist, gemessen.

16. Verfahren für die Produktion eines Artikels, der fotokatalytische Aktion manifestiert, umfassend:
i) Erhalten einer Regressionslinie oder eines Regressionsausdrucks oder beides für eine Beziehung zwischen der arithmetischen Durchschnitts-Oberflächenrauheit (Ra) einer Oberfläche eines Artikels, wie in einem Gebiet von 100 µm x 100 µm mittels eines Lasermikroskops gemessen, und eines Wassertröpfchen-Kontaktwinkels (Ca) einer oberen Oberfläche des Artikels, wie nach Bestrahlung für 24 Stunden mit einem Schwarzlicht, das eine Intensität von 1,0 mW/cm² aufweist, gemessen, wobei eine fotokatalytischer Film und ein hydrophiler Film in Reihenfolge auf der Oberfläche mittels physikalischer oder chemischer Gasphasenabscheidung unter einer gegebenen Bedingung gebildet werden;
ii) Auswählen eines Artikels, der behandelt werden soll;
iii) Bestimmen eines gewünschten Ca auf einem Gebiet des Artikels;
iv) Bestimmen einer gewünschten Ra auf dem Gebiet, welche 0,78 µm oder weniger ist, für den gewünschten Ca basierend auf der Regressionslinie oder des Regressionsausdrucks oder beiden;
v) Bearbeiten des Gebietes, um seine Ra auf die gewünschte Ra einzustellen,
vi) Bilden eines fotokatalytischen Films und eines hydrophilen Films in Reihenfolge auf dem Gebiet mittels physikalischer oder chemischer Gasphasenabscheidung unter der gegebenen Bedingung;
wobei das Material der Oberfläche auf einem Artikel ausgewählt ist aus der Gruppe aus
Edelstahl, kalt gewalztem Stahlblatt, Aluminium, Aluminiumoxid (alumite), Eisen, Nickel, Titan, Messing; Polyimid, ABS (Polyacrylnitril-Butadien-Styrol-Harz), PP (Polypropylen), PE (Polyethylen), PS (Polysterol), PMMA (Acryl), PET (Polyethylenterephthalat), PPE (Polyphenylenether), PA (Nylon/Polyamid), PC (Polycarbonat), POM (Polyacetal), PBT (Polybutylenterephthalat), PPS (Polyphenylensulfid), PEEK (Polyetheretherketon), LCP (Flüssigkristall-Polymer), Fluorharz, Urethan-Harz, Elastomer; Glas und Keramik;
wobei der fotokatalytische Film aus TiO₂ gebildet wird;
wobei der fotokatalytische Film aus TiO₂ eine Dicke von 50 bis 400 nm aufweist, und
wobei der hydrophile Film eine poröse Struktur aufweist und aus SiO₂ gebildet wird,
wobei der hydrophile Film aus SiO₂ eine Dicke von 1 bis 400 nm aufweist und eine poröse Struktur hat.

17. Verfahren gemäß Anspruch 16, wobei der Schritt des Erhaltens der Regressionslinie oder des Regressionsausdrucks oder beider verschiedene Artikel verwendet, die aus verschiedenen Materialien hergestellt sind.

18. Verfahren gemäß Anspruch 16, wobei eine Oberfläche des hydrophilen Films einen Ca von ungefähr 20° oder weniger aufweist.

## Revendications

1. Article comprenant:
a) une surface
où le matériau de ladite surface est sélectionné du groupe de acier inoxydable, une feuille en acier laminée à froid, aluminium, alumite, fer, nickel, titane, laito; polyimide, ABS (résine de polyacrylonitrile-butadiène-styrène), PP (polypropylène), PE (polyéthylène), PS (polystyrène), PMMA (acrylique), PET (polyéthylène téréphtalate), PPE (polyphénylène éther), PA (nylon/polyamide), PC (polycarbonate), POM (polyacétal), PBT (polybutylène téréphtalate), PPS (polysulfure de phénylène), PEEK (polyétheréthercétone), LCP (polymère à cristaux liquides), résine fluorée, résine uréthane, élastomère; verre, et céramique,
où ladite surface a une rugosité arithmétique moyenne de surface (Ra) de 0,78 µm ou moins telle qu'on la mesure dans une superficie de 100µm x 100µm par un microscope laser;
b) un film photo-catalytique déposé sur la surface
où ledit film photo-catalytique est constitué par du TiO₂;
où le film photo-catalytique en TiO₂ a une épaisseur allant de 50 à 400nm; et
c) un film hydrophile déposé sur le film photo-catalytique et exposé à l'environnement externe
où le film hydrophile est constitué par du SiO₂,
où le film hydrophile en SiO₂ a une épaisseur allant de 1 à 400nm et possède une structure poreuse.

2. Article selon la revendication 1, où le film photo-catalytique et le film hydrophile sont des films déposés par le biais d'un dépôt physique ou chimique en phase vapeur.

3. Article selon la revendication 1 ou 2, où une surface du film hydrophile a un angle de contact des gouttelettes d'eau d'environ 20° ou moins tel qu'on le mesure après irradiation pendant 24 heures à l'aide d'une lumière noire dont l'intensité est de 1,0mW/cm².

4. Article selon l'une des revendications 1 à 3, qui est une caméra comprenant un objectif de la caméra ou du verre de protection et un dispositif de retenue retenant l'objectif de la caméra ou le verre de protection à sa périphérie externe, où la surface comprend une surface du dispositif de retenue.

5. Article selon la revendication 4, dans lequel la surface du dispositif de retenue possède une Ra de 0,60-0,78µm, et une surface du film hydrophile a un angle de contact des gouttelettes d'eau d'environ 15° à environ 20° tel qu'on le mesure après irradiation pendant 24 heures à l'aide d'une lumière noire dont l'intensité est de 1,0mW/cm².

6. Article selon l'une quelconque des revendications 1 à 3, qui est une partie d'une bicyclette, où la surface comprend une surface de la partie de la bicyclette.

7. Article selon l'une quelconque des revendications 1 à 3, qui est un dispositif de radar laser comprenant une unité de radar laser et un organe capot du radar laser, où l'organe capot du radar laser est un moulage de résine polyimide, et la surface comprend une surface de l'organe capot du radar laser.

8. Article selon la revendication 7, dans lequel la surface de l'organe capot du radar laser a une Ra de 0,2µm ou moins, et une surface du film hydrophile a un angle de contact des gouttelettes d'eau d'environ 4° ou moins tel qu'on le mesure après irradiation pendant 24 heures à l'aide d'une lumière noire dont l'intensité est de 1,0mW/cm².

9. Procédé pour produire un article manifestant une action photo-catalytique, comprenant le fait de:
i) déterminer une surface d'un article, devant manifester l'action photo-catalytique où le matériau de ladite surface d'un article est sélectionnée du groupe de acier inoxydable, une feuille en acier laminée à froid, aluminium, alumite, fer, nickel, titane, laito; polyimide, ABS (résine de polyacrylonitrile-butadiène-styrène), PP (polypropylène), PE (polyéthylène), PS (polystyrène), PMMA (acrylique), PET (polyéthylène téréphtalate), PPE (polyphénylène éther), PA (nylon/polyamide), PC (polycarbonate), POM (polyacétal), PBT (polybutylène téréphtalate), PPS (polysulfure de phénylène), PEEK (polyétheréthercétone), LCP (polymère à cristaux liquides), résine fluorée, résine uréthane, élastomère; verre, et céramique;
ii) déterminer si la surface a une rugosité arithmétique moyenne de surface (Ra) de 0,78µm ou moins telle qu'on la mesure dans une superficie de 100µm x 100µm à l'aide d'un microscope laser;
iii) si Ra est supérieure à 0,78µm, ajuster la Ra à 0,78µm ou moins;
iv) former un film photo-catalytique sur la surface par le biais d'un dépôt physique ou chimique en phase vapeur
où le film photo-catalytique est constitué par du TiO₂;
où le film photo-catalytique en TiO₂ a une épaisseur allant de 50 à 400nm, et
v) former un film hydrophile sur le film photo-catalytique par le biais d'un dépôt physique ou chimique en phase vapeur
où le film hydrophile est constitué par du SiO₂
où le film hydrophile en SiO₂ a une épaisseur allant de 1 à 400nm et possède une structure poreuse.

10. Procédé selon la revendication 9, dans lequel une surface du film hydrophile a un angle de contact des gouttelettes d'eau d'environ 20° ou moins tel qu'on le mesure après irradiation pendant 24 heures à l'aide d'une lumière noire dont l'intensité est de 1,0mW/cm².

11. Procédé selon la revendication 9 ou 10, dans lequel l'article est une caméra comprenant un objectif de la caméra ou du verre de protection et un dispositif de retenue retenant l'objectif de la caméra ou le verre de protection à sa périphérie externe, où la surface comprend une surface du dispositif de retenue.

12. Procédé selon la revendication 11, dans lequel l'étape d'ajustement de la Ra comprend l'ajustement de la Ra à 0,60-0,78µm, où une surface du film hydrophile a un angle de contact des gouttelettes d'eau d'environ 15° à environ 20° tel qu'on le mesure après irradiation pendant 24 heures à l'aide d'une lumière noire dont l'intensité est de 1,0mW/cm².

13. Procédé selon la revendication 9 ou 10, dans lequel l'article est une partie d'une bicyclette, où la surface comprend une surface de la partie de la bicyclette.

14. Procédé selon la revendication 9 ou 10, dans lequel l'article est un dispositif de radar laser comprenant une unité de radar laser et un organe capot du radar laser, où l'organe capot du radar laser est un moulage de résine polyimide, et la surface comprend une surface de l'organe capot du radar laser.

15. Procédé selon la revendication 14, dans lequel l'étape d'ajustement de la Ra comprend l'ajustement de la Ra à 0,2µm ou moins, où une surface du film hydrophile a un angle de contact des gouttelettes d'eau d'environ 4° ou moins tel qu'on le mesure après irradiation pendant 24 heures à l'aide d'une lumière noire dont l'intensité est de 1,0mW/cm².

16. Procédé pour produire un article manifestant une action photo-catalytique, comprenant le fait de:
i) obtenir une ligne de régression ou une expression de régression ou les deux à la fois d'une relation entre la rugosité arithmétique moyenne de surface (Ra) d'une surface d'un article telle qu'on la mesure dans une superficie de 100µm x 100µm à l'aide d'un microscope laser et un angle de contact des gouttelettes d'eau (Ca) d'une surface supérieure de l'article tel qu'on le mesure après irradiation pendant 24 heures à l'aide d'une lumière noire dont l'intensité est de 1,0mW/cm², où un film photo-catalytique et un film hydrophile sont formés de manière séquentielle sur la surface par le biais d'un dépôt physique ou chimique en phase vapeur dans une condition donnée;
ii) sélectionner un article à traiter;
iii) déterminer un Ca désiré d'une surface de l'article;
iv) déterminer une Ra désirée de la surface qui est de 0,78µm ou moins pour le Ca désiré sur la base de la ligne de régression ou l'expression de régression ou les deux à la fois;
v) traiter la surface pour ajuster sa Ra à la Ra désirée,
vi) former un film photo-catalytique et un film hydrophile de manière séquentielle sur la surface par le biais d'un dépôt physique ou chimique en phase vapeur dans la condition donnée;
où le matériau de ladite surface d'un article est sélectionné du groupe de
acier inoxydable, une feuille en acier laminée à froid, aluminium, alumite, fer, nickel, titane, laito; polyimide, ABS (résine de polyacrylonitrile-butadiène-styrène), PP (polypropylène), PE (polyéthylène), PS (polystyrène), PMMA (acrylique), PET (polyéthylène téréphtalate), PPE (polyphénylène éther), PA (nylon/polyamide), PC (polycarbonate), POM (polyacétal), PBT (polybutylène téréphtalate), PPS (polysulfure de phénylène), PEEK (polyétheréthercétone), LCP (polymère à cristaux liquides), résine fluorée, résine uréthane, élastomère; verre, et céramique,
où le film photo-catalytique est constitué par du TiO₂;
où le film photo-catalytique en TiO₂ a une épaisseur allant de 50 à 400nm; et
où le film hydrophile possède une structure poreuse et est constitué par du SiO₂,
où le film hydrophile en SiO₂ a une épaisseur allant de 1 à 400nm et possède une structure poreuse.

17. Procédé selon la revendication 16, dans lequel l'étape d'obtention de la ligne de régression ou de l'expression de régression ou les deux à la fois utilise différents articles réalisés à partir de différents matériaux.

18. Procédé selon la revendication 16, dans lequel une surface du film hydrophile a un Ca d'environ 20° ou moins.
